# EUROPEAN PATENT APPLICATION

(11) **EP 3 413 241 A1**
(43) Date of publication of application: **12.12.2018**
(21) Application number: 17305697.9
(22) Date of filing: 09.06.2017
(51) Int. Cl.: G06K 19/07, G06K 19/067, G06K 19/077

(54) **PIEZOELECTRIC RF IDENTIFICATION (RFID) ANTENNAS**

(71) Applicant: Thomson Licensing, 92130 Issy-les-Moulineaux (FR)
(72) Inventor: LOUZIR, Ali, 35576 Cesson-Sévigné (FR); KUMAR, Rupesh, 35576 Cesson-Sévigné (FR); LE NAOUR, Jean-Yves, 35576 Cesson-Sévigné (FR); GILBERTON, Philippe, 35576 Cesson-Sévigné (FR)
(74) Representative: Huchet, Anne

(57) **Abstract**

A sensor including an integrated circuit and a piezoelectric substrate is described. The piezoelectric substrate is adapted as an antenna of an integrated circuit. The antenna may be an RFID antenna and the integrated circuit may be and RFID integrated circuit.

## Description

### FIELD

The proposed apparatus is directed to radio-frequency identification devices (RFIDs) operating in the ultra-high frequency band.

### BACKGROUND

This section is intended to introduce the reader to various aspects of art, which may be related to embodiments that are described below. This discussion is believed to be helpful in providing the reader with background information to facilitate a better understanding of the various aspects of the present disclosure. Accordingly, it should be understood, that these statements are to be read in this light.

Radio-frequency identification (RFID) is a generic term for technologies that use radio waves to automatically identify people or objects. An RFID system uses tags, or labels attached to the objects to be identified. Two-way radio transmitter-receivers called interrogators or readers send a signal to the tag and read its response. There are several types of RFID tags, depending on range, size, cost and underlying technology.

RFID tags can be passive, active or battery-assisted (or semi) passive. An active tag has an on-board battery and periodically transmits an ID signal. A battery-assisted passive (BAP) tag has a small battery on board and is activated when in the presence of an RFID reader. A passive tag ls cheaper and smaller because it has no battery, instead, the tag uses the radio energy transmitted by the reader as the power source. However, to operate a passive tag, it must be illuminated with a power level roughly a thousand times stronger than for signal transmission. That makes a difference in interference and in exposure to radiation. The energy conversion is performed by an RF energy harvester generally including an antenna and a rectifier/multiplier tuned to the waves received from the RFID reader.

Tags may either be read-only, having a factory-assigned serial number that is used as a key into a database, or may be read/write, where object-specific data can be written into the tag by the system user. Field programmable tags may be write-once, read-multiple; "blank" tags may be written with an electronic product code by the user.

RFID tags contain at least two parts: an integrated circuit (IC, microchip or chip) for storing and processing information, modulating and demodulating a radio-frequency (RF) signal, collecting DC power from the incident reader signal, and other specialized functions; and an antenna for receiving and transmitting the signal. The tag information is stored in a non-volatile memory. The RFID tags includes either fixed or programmable logic for processing the transmission and sensor data, respectively.

An RFID reader transmits an encoded radio signal to interrogate the tag. The RFID tag receives the message and then responds with its identification and/or other information. This may be only a unique tag serial number, or may be product-related information such as stock number, lot or batch number, production date, or other specific information. Since tags have individual serial numbers, the RFID system design can discriminate among several tags that might be within the range of the RFID reader and read them simultaneously.

RFID systems may be classified in two major classes operating in different frequency bands. The difference between the two classes is based on the type of physical coupling between the reader and the tag, which could be either magnetic (inductive coupling) or electromagnetic (radiative coupling). Inductive or magnetic coupling (MC) occurs when a varying magnetic field exists between two parallel conductors typically less than a wavelength apart, inducing a change in voltage along the receiving conductor. It generally applies to frequencies up to the Very High Frequency (VHF) range, around 100 MHz. In RFID systems based on inductive coupling, the tag gets its energy from the proximately coupled magnetic field and responds by loading its own antenna with different impedances.

Radiative or electromagnetic coupling occurs when the source and the target (or victim) are separated by a large distance, typically more than a wavelength. The source and the target act as radio antennas: the source emits or radiates an electromagnetic wave which propagates across the space in between and is picked up or received by the target. Radiative coupling generally applies to frequencies above 100 MHz. In RFID systems based on radiative coupling, the tag gets its energy from the electromagnetic field radiated by the reader and reflects it back, modulating with its own impedances presenting different Radar Cross Section (RCS). RCS is a measure of the ability of a target to reflect radar signals in the direction of the radar receiver.

The coupling nature of the first class (inductive coupling) limits the read range to an order of magnitude of the size of the reader or the tag antenna (generally a few centimeters) while the range of the second class (radiative coupling) could reach up to tens of meters depending on the nature of the tags (passive and active) and its sensitivity. For long range RFID systems operating in the Ultra High Frequency (UHF) band or microwave bands using passive tags, a part of the incoming RF signal (issued from the remote RFID reader and coupled through the tag antenna) is converted to DC for the supply of the chip. Once the chip is activated, the received signal is demodulated by the interface and reflected back (backscattered) modulated by the information stored in the chip memory. The chip activation is the limiting factor of the achievable range of RFID systems using passive tags. Typical ranges of 10 meters are currently achievable in Line of Sight (LOS) conditions using state of the art passive tags and readers.

The Electronic Product Code (EPC^{™}) Generation 2 (Gen2) air interface protocol defines the physical and logical requirements for an RFID system of interrogators and passive tags, operating in the 860 MHz - 960 MHz UHF (or also called 900 MHz) band. Over the past decade, EPC Gen2 has established itself as the standard for UHF implementations across multiple sectors, and is at the heart of more and more RFID implementations.

More recently with the explosion of wireless sensors, a new generation of RFID chips compliant with the EPC Gen2 standard has emerged with a power supply input to be connected to a coin-size battery, increasing the device range to several tens of meters. The new devices are not strictly passive, but may be considered semi-passive devices. However, battery life is not only inconvenient but may also be fatal to the commercial success of these new generation devices due to the complexity and cost of replacing batteries.

While RFID tags are now established as a standard technology for object identification and tracking, some research is aimed towards extending the capability of RFID tags, including passive tags beyond the identification function (RFID beyond ID). Specifically, RFID tags and systems are combining the identification function with a sensing of a physical or biological signal. For many such systems, a sensing module (for example, temperature, pressure, etc.) is coupled to the RFID chip through a secondary wired interface to store/update the sensed data in the memory of the chip.

### SUMMARY

The proposed apparatus concerns an antenna which is augmented with sensing capability for use in a wireless system. It will be appreciated that the proposed apparatus is not limited to any specific type of device and may be applied to any wireless communication device, such as for example a radio frequency identification device (RFID).

According to a first aspect of the disclosure, there is provided a sensor comprising an integrated circuit and a piezoelectric substrate, wherein the piezoelectric substrate is adapted as an antenna of the integrated circuit.

In another embodiment, the antenna is an RFID antenna and the integrated circuit is and RFID integrated circuit.

In another embodiment, the piezoelectric substrate is flexible.

In another embodiment, the piezoelectric substrate is metallized.

In another embodiment, the piezoelectric substrate is formed of a material selected from the group consisting of polyvinylidiene fluoride (PVDF) and copolymers of polyvinylidiene fluoride (PVDF).

In another embodiment, the antenna senses at least one of vibrational energy, acoustic energy and impact energy.

In another embodiment, the piezoelectric substrate converts the sensed at least one of vibrational energy, acoustic energy and impact energy to electrical energy.

In another embodiment, at least a portion of the converted electrical energy is used for at least one of powering the integrated circuit and storing detected signal information in a memory of the integrated circuit.

According to a second aspect of the disclosure a method is disclosed for sensing at least one of vibrational energy, acoustic energy and impact energy using an antenna disposed on a piezoelectric substrate; and then the sensed at least one of vibration energy, acoustic energy and impact energy is converted to electrical energy.

In another embodiment, the method further comprises using at least a portion of the converted electrical energy for at least one of powering an integrated circuit coupled to the antenna and storing sensed signal information in a memory of the integrated circuit.

Some processes implemented by elements of the disclosure may be computer implemented. Accordingly, such elements may take the form of an entirely hardware embodiment, an entirely software embodiment (including firmware, resident software, microcode, etc.) or an embodiment combining software and hardware aspects that may all generally be referred to herein as "circuit", "module" or system. Furthermore, such elements may take the form of a computer program product embodied in any tangible medium of expression having computer usable program code embodied in the medium.

Since elements of the present disclosure can be implemented in software, the present disclosure can be embodied as computer readable code for provision to a programmable apparatus on any suitable carrier medium. A tangible carrier medium may comprise a storage medium such as a floppy disk, a CD-ROM, a hard disk drive, a magnetic tape device or a solid-state memory device and the like. A transient carrier medium may include a signal such as an electrical signal, an optical signal, an acoustic signal, a magnetic signal or an electromagnetic signal, e.g. a microwave or RF signal.

### BRIEF DESCRIPTION OF THE DRAWINGS

Embodiments of the disclosure will now be described, by way of example only, and with reference to the following drawings in which:
FIG. 1 illustrates a simplified block diagram of an exemplary RFID system in accordance with an embodiment of the present disclosure;
FIG. 2 illustrates a simplified block diagram of an exemplary RFID tag device in accordance with an embodiment of the present disclosure;
FIG. 3 shows an exemplary flexible piezoelectric film having a metal layer disposed thereon;
FIG. 4A illustrates a planar view of the metallized piezoelectric film shown in FIG. 3;
FIG. 4B illustrates a schematic side view of the metallized piezoelectric film shown in FIG. 3; and
FIG. 5 illustrates a flowchart of an exemplary method in accordance with one embodiment of the disclosure.

It should be understood that the drawings are for purposes of illustrating the concepts of the disclosure and is not necessarily the only possible configuration for illustrating the disclosure.

### DETAILED DESCRIPTION

The present disclosure is directed to a radio frequency identification device (RFID) capable of sensing mechanical impact, vibrational energy and/or acoustic signals.

Fundamentally, a passive RFID device acts as an energy harvester. The RF energy harvesting may be performed by an antenna and a rectifier/multiplier tuned to the waves received from the RFID reader. Indeed, a portion of the energy of an incoming RF signal, transmitted by the RFID reader, and coupled through the RFID antenna, may be converted to DC by the rectifier/multiplier for the supply of the RFID chip and is thus not used for the wireless communication link.

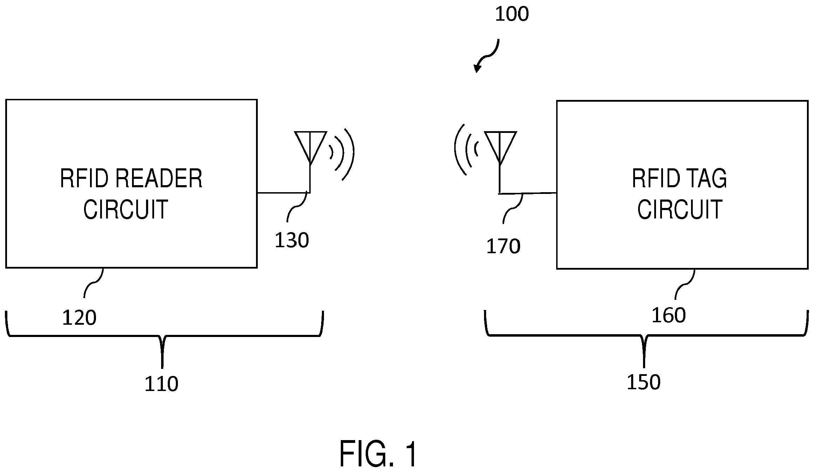

FIG. 1 illustrates a simplified block diagram of an exemplary RFID system 100 in accordance with an embodiment of the present disclosure. RFID system 100 includes RFID reader device 110 and RFID tag device 150. RFID reader device 110 includes RFID reader circuit 120 coupled to RFID reader antenna 130. RFID tag device 150 includes RFID tag circuit 160 coupled to RFID tag antenna 170. The RFID tag device 150 may be attached to the object to be sensed, using, for example, an adhesive film.

RFID reader device 110 generates and modulates a request message in RFID reader circuit 120 to create a transmitter signal, and radiates the transmitter signal via electromagnetic waves through antenna 130. RFID tag antenna 170 is tuned to receive the waves radiated from RFID reader antenna 130. An antenna is a specialized transducer or converter that converts RF fields into Alternating Current (AC) or vice-versa. RFID tag antenna 170 converts electromagnetic fields of the received waves to an electrical signal.

RFID tag device 150 draws power from the electrical signal and uses it to power up RFID tag circuit 160. The electrical signal may fully power up the RFID tag circuit 160, in a passive RFID tag, or partially power up the RFID tag circuit 160, in the case of a semi-passive RFID tag. RFID tag circuit 160 also receives and demodulates the electrical signal to retrieve the request message. RFID circuit 160 then generates and modulates a response message with its identification number(s) and/or other information. The modulated response message is radiated via electromagnetic waves through RFID tag antenna 170.

One of the aspects of passive and semi-passive RFID tags is the method of re-modulating an RFID reader electromagnetic wave via backscattering. Since RFID tags are designed to generally have a reactive (e.g., capacitive) impedance, any incoming electromagnetic wave is reflected (re-radiated) by an antenna to its source. Thus, when RFID reader device 110 transmits an electromagnetic wave to RFID tag device 150, the wave is reflected by the RFID tag device 150 back toward the RFID reader device 110. Due to this reflective characteristic, RFID tag device 150 is able to encode a message by modulating the re-radiated electromagnetic wave. Actual modulation of the wave may occur as a transistor in RFID tag circuit 160 rapidly switches between two discrete impedance states. Since each impedance state may have both a resistive and a capacitive characteristic (real and imaginary impedance), the RFID tag device 150 may perform both phase and amplitude modulation of the re-radiated signal.

RFID reader device 110 may receive the re-radiated waves through RFID reader antenna 130 and convert the waves to digital data containing the response message. It is to be understood that RFID reader circuit 120 may be any RFID reader circuit or IC well-known to one of ordinary skill in the pertinent art. Likewise, RFID reader antenna 130 may be any antenna well-known to one of ordinary skill in the pertinent art, e.g., dipole antennas, loop antennas, inverted-F antennas, monopole antennas, patch or micro-strip antennas, etc.

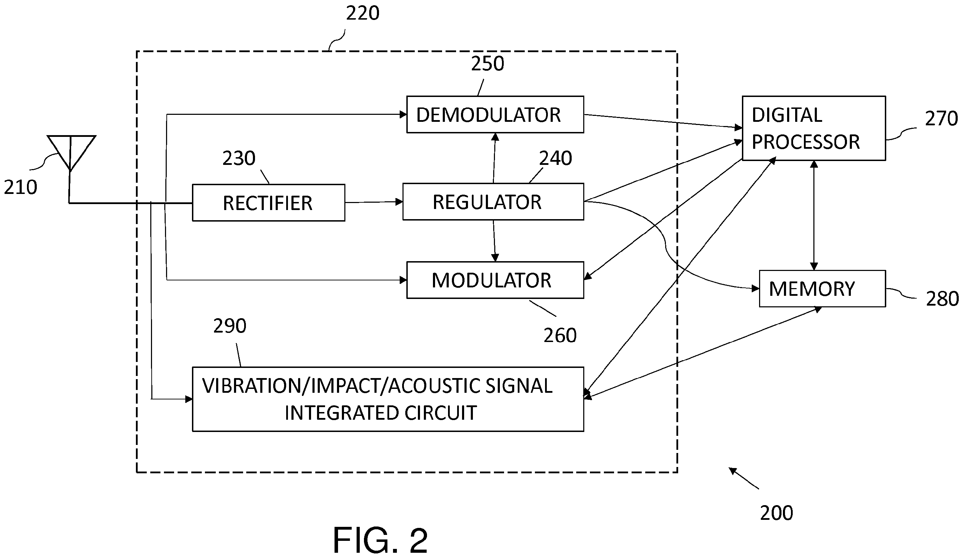

FIG. 2 illustrates a simplified block diagram of an exemplary RFID tag device 200 in accordance with an embodiment of the present disclosure. RFID tag device 200 may be similar to RFID tag device 150. RFID tag device 200 includes RFID antenna 210. RFID tag device 200 also includes analog front end (AFE) 220, digital processor 270 and memory 280, which together are similar to RFID tag circuit 160.

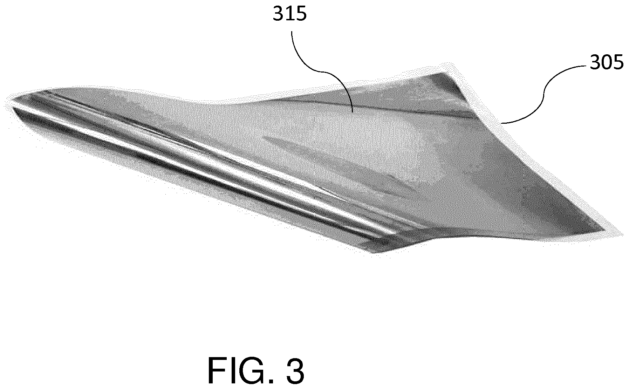

Antenna 210 preferably operates in the Ultra High Frequency (UHF) band. Antenna 210 is augmented with the capability of sensing any mechanical impact, vibration or acoustic signal. In one aspect of the disclosure, antenna 210 is formed on a piezoelectric film. FIG. 3 shows an exemplary flexible piezoelectric film 305 that has a metal layer 315 disposed thereon.

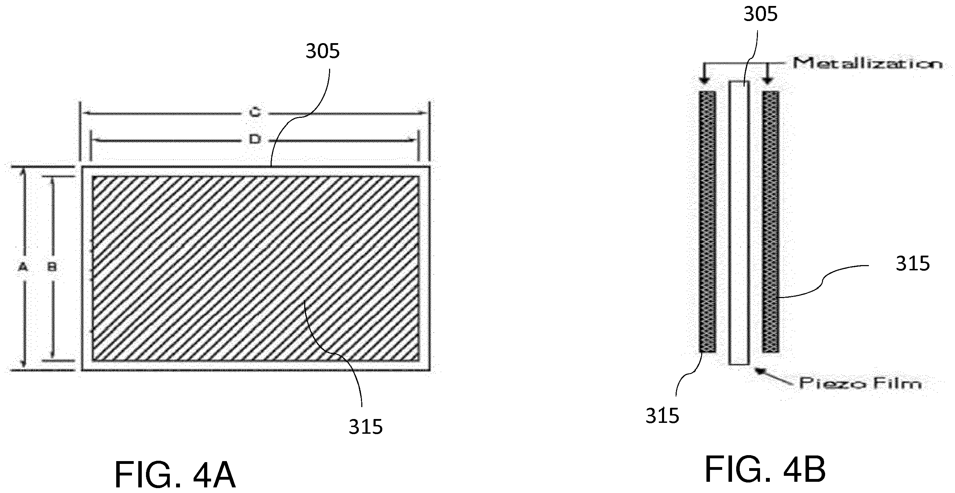

FIG. 4A illustrates a planar view of the metallized piezoelectric film shown in FIG. 3. In FIG. 4A, the metal layer 315 is disposed on the piezoelectric film 305. FIG. 4B illustrates a schematic side view of the metallized piezoelectric film shown in FIG. 3. In FIG 4B, both sides of the piezoelectric film 305 have a metal layer 315 disposed thereon. The metal layer that is depicted in FIGS. 4A-4B, has a square shape. However, several topologies and shapes for the antenna are contemplated and are a matter of design choice.

Piezoelectric films typically have a relative permittivity, in the range of 12-13. Such a relative permittivity allows for smaller antenna sizes in comparison to antennas disposed on conventional substrates. The relative permittivity of conventional substrates is typically in the range of 2-4. Thus, for example, a substrate having a relative permittivity about four (4) times higher than a conventional substrate may have antennas with sizes about two (2) times smaller than those disposed on a conventional substrate with the same performance.

In addition to antenna 210 operating in the UHF frequency band, the antenna is also an efficient mechanical to electrical transducer for the detection and/or the acquisition of an impact, vibration or acoustic signal due to its disposition on the piezoelectric film. Suitable examples for the piezoelectric film include polyvinylidene fluoride (PVDF) and copolymers of polyvinylidene fluoride.

AFE 220 is coupled to antenna 210 and includes rectifier 230, regulator 240, demodulator 250, modulator 260 and vibration/impact/acoustic signal integrated circuit 290. Rectifier 230 performs the function of rectification/multiplication of the received electrical signal and provides Direct Current (DC) power to regulator 240. An RF energy harvester is built around an RF rectifier which is an electrical circuit that converts RF power from a lower voltage to a higher DC voltage using a network of capacitors and diodes. The RFID antenna 210 input is connected to a diode rectifier through a matching network and for given diode characteristics and fixed RF input power, the load is optimized for a maximum RF to DC converter efficiency. As an example, the HSMS-286 family of RF detector diodes from Avago^{™} is well suited for use in energy harvesting from 900 MHz up to 5.8 GHz frequency range.

Regulator 240 is coupled to rectifier 230 and regulates input power to desired levels by the remaining components of RFID tag device 200, which are coupled to regulator 240. Demodulator 250 is coupled to regulator 240 and to antenna 210 and receives and demodulates the input electrical signal to receive the request message and possibly control signals from the RFID reader (e.g., RF reader device 110). Modulator 260 is coupled to regulator 240 and to antenna 210, and modulates a response message including its identification number(s) and/or other information, and possibly control signals. The modulated response message is radiated via electromagnetic waves through RFID tag antenna 210.

Vibration/impact/acoustic signal integrated circuit (IC) 290 is coupled to antenna 210 and receives sensed mechanical impact, vibration, or acoustic signals therefrom. Vibration/impact/acoustic signal IC 290 converts the mechanical, vibrational or acoustic signals to electrical energy, a portion of which may be used for powering, detecting and storing the detected signal information in the memory 280 of the chip. The vibration/impact/acoustic signal IC 290 preferably includes an amplifier and an Analog-to-Digital circuit (not shown) which are used for post-processing signals from digital processor 270 or for storing the information in the memory 280. For example, in the case of impact detection, vibration/impact/acoustic signal integrated circuit 290 may be a simple state machine based IC which provides two output states depending on the level of the analog input signal as compared to a programmable threshold value. Alternatively, a battery (not shown) could be used for the power supply of a high-speed Analog-to-Digital convertor (ADC) or a microcontroller when required, while the antenna 210 only provides the impact, the vibration or the acoustic signal information to be stored.

Digital processor 270 is coupled to regulator 240, demodulator 250 and modulator 260. Digital processor 270 receives and interprets a digital request message and control signals from demodulator 250 and requests identification number(s) and/or other information. Memory 280 may be a non-volatile memory, including a read-only memory (ROM) or a read-write memory. Memory 280 provides the necessary information to digital processor 270 upon request. Digital processor 270 may also include the operations of clock management, data encoding (e.g., error correction encoding), data decoding (e.g., error correction decoding), data encryption, data decryption, anti-collusion, etc. Digital processor 270 may include a digital logic circuit, including e.g., finite state machine(s) (FSM) and registers. Digital processor 270 may include a controller or processor that controls the operation of RFID tag device 200. Digital processor 270 may also generate appropriate control signals and send the response message including identification number(s) and/or other information and possibly control signals to modulator 260.

It is to be understood that the various components of RFID tag device 200 may be well-known circuits to a person of ordinary skill in the art and will not be described in detail. It is to be understood that other well-known components may be present in RFID tag device 200, e.g., a frequency oscillator. It is to be understood that RFID tag device 200 and corresponding RF reader (e.g., RFID reader device 110) may be compliant with at least one RFID standard e.g., the EPC Gen2, the International Standards Organization ISO 18000 series standards, etc.

According to one or more embodiments of the present disclosure, more than one rectifier/multiplier circuits or RF harvester may be included in RFID tag device 200 (not shown), the plurality of rectifiers/multipliers harvesting energy from a plurality of frequency bands.

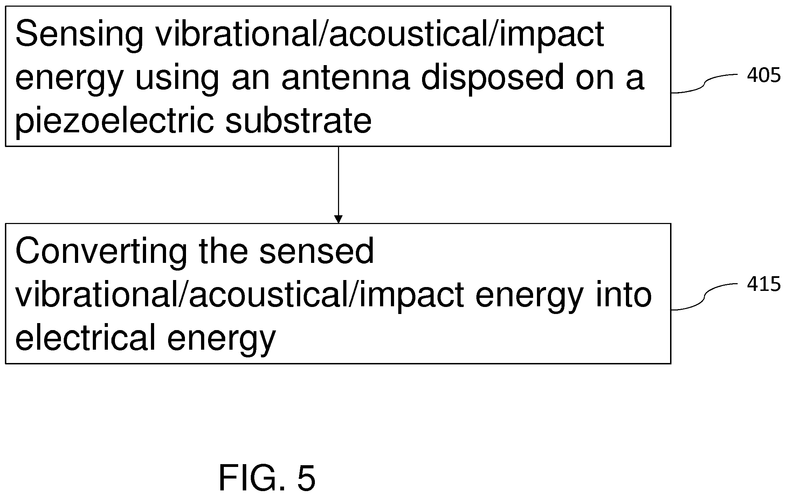

FIG. 5 illustrates a flowchart of an exemplary method in accordance with another aspect of the disclosure. In step 405, at least one of vibrational energy, acoustic energy and impact energy is sensed using an antenna disposed on a piezoelectric substrate. The antenna preferably operating in the UHF frequency band, is an efficient mechanical to electrical transducer for the detection and/or the acquisition of an impact, vibration or acoustic signal due to its disposition on the piezoelectric film. Suitable examples for the piezoelectric film include polyvinylidene fluoride (PVDF) and copolymers of polyvinylidene fluoride.

The sensed at least one of vibration energy, acoustic energy and impact energy is then converted to electrical energy, as depicted in step 415. Vibration/impact/acoustic signal IC converts the mechanical, vibrational or acoustic signals to electrical energy sensed during step 405. A portion of the converted energy may be used for powering, detecting and storing the detected signal information in a memory. Alternatively, a battery (not shown) could be used for the power supply of a high-speed Analog-to-Digital convertor (ADC) or a microcontroller when required, while the antenna only provides the impact, the vibration or the acoustic signal information to be stored.

It should be understood that the elements shown in the figures may be implemented in various forms of hardware, software or combinations thereof. Preferably, these elements are implemented in a combination of hardware and software on one or more appropriately programmed general-purpose devices, which may include a processor, memory and input/output interfaces. Herein the phrase "coupled" is defined to mean directly connected to or indirectly connected with, through one or more intermediate components. Such intermediate components may include both hardware and software based components.

The present description illustrates the principles of the present disclosure. It will thus be appreciated that those skilled in the art will be able to devise various arrangements that, although not explicitly described or shown herein, embody the principles of the disclosure and are included within its scope.

All examples and conditional language recited herein are intended for educational purposes to aid the reader in understanding the principles of the disclosure and the concepts contributed by the inventors to furthering the art, and are to be construed as being without limitation to such specifically recited examples and conditions.

Moreover, all statements herein reciting principles, aspects, and embodiments of the disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagram presented herein represents conceptual views of illustrative circuitry embodying the principles of the disclosure. Similarly, it will be appreciated that any flow charts, flow diagrams, state transition diagrams, pseudocode and the like represent various processes which may be substantially represented in computer readable media and so executed by a computer or processor, whether or not such computer or processor is explicitly shown.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, read only memory (ROM) for storing software, random access memory (RAM), and nonvolatile storage.

Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

In the claims, hereof, any element expressed as a means for performing a specified function is intended to encompass any way of performing that function including, for example, a) a combination of circuit elements that performs that function or b) software in any form, including, therefore, firmware, microcode or the like, combined with appropriate circuitry for executing that software to perform the function. The disclosure as defined by such claims resides in the fact that the functionalities provided by the various recited means are combined and brought together in the manner which the claims call for. It is thus regarded that any means that can provide those functionalities are equivalent to those shown herein.

## Claims

1. A sensor, comprising:
an integrated circuit (220); and
a piezoelectric substrate (305), wherein the piezoelectric substrate is adapted as an antenna of the integrated circuit (210).

2. The sensor according to claim 1, wherein the antenna is an RFID antenna and the integrated circuit is an RFID integrated circuit.

3. The sensor according to any of the preceding claims, wherein the piezoelectric substrate is flexible.

4. The sensor according to any of the preceding claims, wherein the piezoelectric substrate is metallized.

5. The sensor according to any of the preceding claims, wherein the piezoelectric substrate is formed of a material selected from the group consisting of polyvinylidiene fluoride (PVDF) and copolymers of polyvinylidiene fluoride (PVDF).

6. The sensor according to any of the preceding claims, wherein the antenna senses at least one of vibrational energy, acoustic energy and impact energy.

7. The sensor according to claim 6, wherein the piezoelectric substrate converts the sensed at least one of vibrational energy, acoustic energy and impact energy into electrical energy.

8. The sensor according to claim 7, wherein at least a portion of the converted electrical energy is used for at least one of powering the integrated circuit and storing detected signal information in a memory of the integrated circuit.

9. A method, comprising:
sensing (405) at least one of vibrational energy, acoustic energy and impact energy using an antenna disposed on a piezoelectric substrate; and
converting (415) the sensed at least one of vibration energy, acoustic energy and impact energy into electrical energy.

10. The method of claim 9, further comprising:
using at least a portion of the converted electrical energy for at least one of powering an integrated circuit coupled to the antenna and storing detected signal information in a memory of the integrated circuit.

11. The method of claim 10, wherein the antenna is an RFID antenna and the integrated circuit is an RFID integrated circuit.

12. The method of any of claims 9-11, wherein the piezoelectric substrate is formed of a material selected from the group consisting of polyvinylidiene fluoride (PVDF) and copolymers of polyvinylidiene fluoride (PVDF).

13. A device comprising a sensor according to any one of claims 1 to 8.

14. A computer program product for a programmable apparatus, the computer program product comprising a sequence of instructions for implementing a method according to any of claims 9-12, when loaded into and executed by the programmable apparatus.
